(19) Europäisches Patentamt / European Patent Office / Office européen des brevets

(11) **EP 4 769 241 A1**

(12) **EUROPEAN PATENT APPLICATION**
published in accordance with Art. 153(4) EPC

(43) Date of publication:
**01.07.2026   Bulletin 2026/27**

(21) Application number: **24856260.5**

(22) Date of filing: **02.08.2024**

(51) International Patent Classification (IPC):
**G06N 10/40** (2022.01)    **G06N 10/70** (2022.01)
**H10N 60/00** (2023.01)

(52) Cooperative Patent Classification (CPC):
**G06N 10/40; G06N 10/70; H10N 60/00**

(86) International application number:
**PCT/JP2024/027820**

(87) International publication number:
**WO 2025/041568 (27.02.2025 Gazette 2025/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:   **22.08.2023   JP 2023134521**

(71) Applicant: **RIKEN
Wako-shi, Saitama 351-0198 (JP)**

(72) Inventors:
• **TAMATE Shuhei**
  **Wako-shi Saitama 351-0198 (JP)**
• **SPRING Peter Anthony**
  **Wako-shi Saitama 351-0198 (JP)**
• **NAKAMURA Yasunobu**
  **Wako-shi Saitama 351-0198 (JP)**

(74) Representative: **Hautier IP - MC/EP
17, avenue Albert II
C/o The Office & Co - L'ALBU
98000 Monaco (MC)**

(54) **FILTER CIRCUIT, QUANTUM DEVICE, QUANTUM COMPUTER, FILTER CIRCUIT MANUFACTURING METHOD, FILTER CIRCUIT ASSEMBLY METHOD, READOUT FREQUENCY FILTERING METHOD, AND QUANTUM BIT DISPERSIVE READOUT METHOD**

(57)    The filter circuit 1 comprises a readout-resonator 11 coupled to a data qubit and a filter-resonator 12 coupled to an observation line. The readout-resonator 11 and the filter-resonator 12 are electromagnetically coupled to each other using capacitive coupling and inductive coupling in parallel.

FIG. 1

**Description**

This disclosure relates to a filter circuit, a quantum device, a quantum computer, a method of manufacturing a filter circuit, a method of assembling a filter circuit, a method of filtering a readout frequency and a method of dispersive readout of a qubit.

BACKGROUND ART

Measuring the state of a qubit is one of the key technologies in quantum computers. In measuring the state of a qubit in a superconducting quantum computing device, a technique referred to as "dispersive readout" is used. In dispersive readout, the electromagnetic field mode of a qubit is coupled to the electromagnetic field mode of a readout-resonator at a sufficient distance in frequency (dispersion region), and the readout-resonator is coupled to an observation line. When reading out the state of the qubit, a microwave with a frequency resonant to the readout-resonator are injected from the observation line and its reflected phase is measured to indirectly estimate the state of the qubit.

One of the problems of dispersive readout is that the mode of the qubit is also indirectly coupled to the observation line. This causes the energy of the qubit to leak out into the observation line, resulting in a phenomenon called decoherence, which causes the qubit to relax (the Purcell effect.) One technique to deal with this is to use a filter circuit called a parcel filter. By adding a parcel filter to a quantum device, the coupling between the readout-resonator and the observation line is maintained, and the relaxation of the energy of the qubit into the observation line is suppressed.

RELATED-ART LITERATURES

Non-PATENT LITERATURES

Non-Patent Literature 1: "Fast Reset and Suppressing Spontaneous Emission of a Superconducting Qubit," M. D. Reed et al, Appl. Phys. Lett. 96(20), 203110 (2010)
Non-Patent Literature 2: "Broadband Filters for Abatement of Spontaneous Emission in Circuit Quantum Electrodynamics", N. Bronn et al. Applied Physics Letters, 107 (17), 172601. (2015)
Non-Patent Literature 3: "Reducing spontaneous emission in circuit quantum electrodynamics by a combined readout/filter technique", N. T. Bronn et al, IEEE Trans. Appl. Supercond. 25(5), 1-10. (2015)
Non-Patent Literature 4: "Fast Readout and Reset of a Superconducting Qubit Coupled to a Resonator with an Intrinsic Purcell Filter", Y. Sunada et al. Phys Rev. Appl. 17,. 044016. (2022)
Non-Patent Literature 5: "Rapid high-fidelity multiplexed readout of superconducting qubits", J. Heinsoo et al. Phys. Rev. Appl. 10(3), 034040. (2018)
Non-Patent Literature 6: "All-microwave leakage reduction units for quantum error correction with superconducting transmon qubits", J. F. Marques, arXiv preprint arXiv:2302.09876 (2023)
Non-Patent Literature 7: "Analysis of multiconductor transmission lines.", C. R. Paul (2007)
Non-Patent Literature 8: "Solution of the transmission-line equations under the weak-coupling assumption," C. R. Paul, IEEE Trans. Elec. Comp. 44(3), 413-423. (2002)

SUMMARY OF INVENTION

TECHNICAL PROBLEM

A first implementation example of a parcel filter is the technique disclosed in Non-Patent Literature 1. In this technique, an observation line is effectively shortcircuited by coupling a quarter-wavelength resonator to the observation line. In this design, a single notch stopband filter can be realized as the filter characteristic. This allows for suppression of energy relaxation at qubit frequencies. However, this scheme requires an extra physical circuit area because of the need to implement an additional quarter-wavelength resonator in the circuit. In a large-scale superconducting quantum computer, even a small increase in circuit area can be an implementation problem, since the circuit area is limited.

A second implementation example of a parcel filter is the technique disclosed in Non-Patent Literature 2. This technique achieves the desired functionality by inserting a wideband stopband filter which is conventionally used in microwave filters between a readout-resonator and an observation line. In this technique, the filter circuit is fabricated on a chip that is independent of the qubit chip. One problem with this implementation technique is that a reflection may occur due to impedance mismatch between the observation line and the filter. The signal loss associated with such a reflection can cause a reduction in measurement efficiency. Another issue is the large increase in circuit area due to the need for an independent filter element.

A third implementation example of a parcel filter is the technique disclosed in Non-Patent Literature 3. In this technique, a capacitive direct coupling is introduced between a qubit and an observation line. This implements a stopband filter that causes destructive interference in the coupling from the qubit through the resonator to the observation line. This type of filter can be considered as a filter that is "intrinsic" to the coupling and does not require additional circuit elements. This may be advantageous in large-scale integration applications where circuit area is limited.

Another example of an intrinsic parcel filter is the technique disclosed in Non-Patent Literature 4. Here, the intrinsic filter is implemented as a distributed constant circuit. By adjusting the coupling position between an observation line and a resonator, it is possible to suppress leakage at the qubit frequency. This technique, as well as the above, has the advantage that it does not require additional circuit elements.

However, one problem in the above techniques is that the readout-resonator is directly coupled to the observation line, and no filtering is applied to the readout-resonator itself. This can be a problem when multiplexing readouts and coupling multiple resonators to a common observation line. The implementation of multiplexed readout is very important in large-scale applications, since multiplexed readout can significantly reduce the number of wires and microwave components in a dilution refrigerator. On the other hand, the coupling of a large number of readout-resonators to a common observation line may cause measurement crosstalk. In particular, it is a major problem when the readout signal enters a different resonator than the target, thereby deteriorating the phase coherence of the qubit.

Individual parcel filter-resonators are a technique introduced to address the problem of readout crosstalk during multiplexing, see, for example, Non-Patent literatures 5 and 6. In readout with individual parcel filter-resonators, multiple readout-resonators are multiplexed onto a single observation line, while each readout-resonator is implemented as a pair of individual parcel filter-resonators. This technique has the advantage of simultaneously suppressing the energy relaxation of a qubit and crosstalk between readout-resonators. This technique was first demonstrated in Non-Patent literature 5 and has been used for 8-multiplexing of readout in 8-qubit devices.

The individual filter-resonators used in Non-Patent literatures 5 and 6 are implemented as bandpass filters that transmit around the readout frequency. As a result, the mechanism simultaneously suppresses the energy relaxation of a qubit. However, this point contains a problem. That is, if the resonator is very strongly coupled to an observation line to speed up the readout, the filter performance as a bandpass filter may not be sufficient, and the energy relaxation of a qubit may not be fully suppressed.

The present disclosure was made in view of these circumstances, and its purpose is to realize a filter circuit that has both a bandpass filter function that transmits only around the readout frequency of the readout-resonator and a notch filter function that suppresses energy relaxation of a qubit into an observation line.


SOLUTION TO PROBLEM

To solve the above problem, a filter circuit of a certain aspect of the present disclosure comprises a readout-resonator coupled to a data qubit, and a filter-resonator coupled to an observation line. The readout-resonator and the filter-resonator are electromagnetically coupled to each other using capacitive coupling and inductive coupling in parallel.

In one embodiment of the filter circuit, the inductive coupling may be realized by mutual inductance between the readout-resonator and the filter-resonator.

In one embodiment, filter circuit may comprise a multiconductor transmission line situated in between the readout-resonator and the filter-resonator. The capacitive coupling and the inductive coupling are realized by the multiconductor transmission line.

In one embodiment of the filter circuit, the readout-resonator may comprise a first readout-resonator section with a first end connected to the data qubit and a second readout-resonator section with a first end grounded. The multi-conductor transmission line is situated in between the second end of the first readout-resonator section and the second end of the first filter-resonator section, and, the second end of the second readout-resonator section and the second end of the second filter-resonator section.

In one embodiment of the filter circuit, the notch frequency $\omega_f$ may satisfy:
[Equation 5]

$$\frac{1}{sinc(\omega_f \ell_c / v_c)} \left[ \frac{\cos(2\omega_f \tilde{\tau}_1) + \cos(2\omega_f \tilde{\tau}_2)}{1 + \cos(2\omega_f [\tilde{\tau}_1 + \tilde{\tau}_2])} \right] = \frac{Z_c^2 + Z_m^2}{Z_c^2 - Z_m^2} \qquad (4)$$

, where the length of the multiconductor transmission line is $l_c$,
where the propagation velocity of the wave propagating through the multiconductor transmission line is $v_c$,
where the capacitance to ground per-unit-length of the first conductor wire and the second conductor wire of the multiconductor transmission line are $C_l$,

where the inductance to ground per-unit-length of the first conductor and the second conductor of the multiconductor transmission line are $L_l$,

where the capacitance per-unit-length between the first conductor and the second conductor of the multiconductor transmission line is $C_m$,

where the inductance per-unit-length between the first conductor and the second conductor of the multiconductor transmission line is $L_m$,

where the length of the second readout-resonator section of the readout-resonator is $l_{r1-G}$,

where the length of the second filter-resonator section of the filter-resonator is $l_{r2-G}$ and

where the variables of the distributed constant circuit are:

[Equation 4]

$$\tilde{\tau}_1 = \frac{\ell_{r1-G}}{v} + \frac{\ell_c}{2v_c}, \quad \tilde{\tau}_2 = \frac{\ell_{r2-G}}{v} + \frac{\ell_c}{2v_c}, \quad v_c = \frac{1}{\sqrt{L_l(C_l+C_m)}}, \quad Z_c = \sqrt{\frac{L_l}{C_l+C_m}}, \quad Z_m = \sqrt{\frac{L_m}{C_m}} \qquad (3)$$

In one embodiment of the filter circuit, the notch frequency $\omega_f$ may satisfy:
[Equation 10]

$$\omega_f = \frac{\pi}{2(\tilde{\tau}_1 + \tilde{\tau}_2)} \qquad (9)$$

In one embodiment of the filter circuit, the coupling constant J between the readout-resonator and the filter-resonator may be expressed by:
[Equation 11]

$$J = \overline{\omega}_{rp} \frac{\pi^2}{32} \frac{\left(\frac{\overline{\omega}_{rp}}{\omega_f} - \frac{\omega_f}{\overline{\omega}_{rp}}\right)}{\cos\left(\frac{\pi\omega_f}{2\overline{\omega}_{rp}}\right)} \left(\frac{C_m}{C_c + C_m}\right) \sin\left(\frac{\omega_f \ell_c}{v_c}\right) \qquad (10)$$

In one embodiment, the filter circuit may comprise a capacitor for coupling in addition to the multiconductor transmission line.

In one embodiment, the filter circuit may comprise a capacitor and an inductor for coupling in addition to the multiconductor transmission line.

In one embodiment, the filter circuit may comprise a capacitor and an inductor situated in between the readout-resonator and the filter-resonator. The capacitive coupling and the inductive coupling are realized by the capacitor and the inductor situated in between the readout-resonator and the filter-resonator, respectively.

Another aspect of the disclosure is a quantum device. This quantum device comprises a data qubit, an observation line and one of the filter circuits described above. The filter circuit is situated in between the data qubit and the observation line.

Yet another aspect of the disclosure is a quantum computer. This quantum computer comprises as described above.

Yet another aspect of the disclosure is a filter circuit. This filter circuit comprises one or more data qubits, one or more readout-resonators corresponding to each of the data qubits, one or more filter-resonators each having a characteristic corresponding to the resonant frequency of the readout-resonators, a coupler circuit situated in between the readout-resonators and the filter-resonators to electrically and magnetically couple the readout-resonators and the filter-resonators and a common observation line. The filter circuit has both bandpass filter characteristics near the readout frequency using the resonance of the filter-resonator, and notch filter characteristics near the qubit frequency using interference in the electrical and magnetic coupler circuit.

Yet another aspect of the disclosure is a method of manufacturing a filter circuit comprising a readout-resonator and a filter-resonator. This method comprises forming a readout-resonator, forming a filter-resonator, coupling the readout-resonator to a data qubit, coupling the filter-resonator to an observation line and electro-magnetically coupling the readout-resonator to the filter-resonator using capacitive coupling and inductive coupling in parallel.

Yet another aspect of the disclosure is a method of assembling a filter circuit. This method comprises providing a readout-resonator component to be coupled with a data qubit, providing a filter-resonator component to be coupled with an observation line and assembling the readout-resonator component and the filter-resonator component to be electro-magnetically coupled to each other using capacitive coupling and inductive coupling in parallel.

Yet another aspect of the disclosure is a method of filtering the readout frequency in dispersive readout of a qubit to an observation line. This method comprises using one of the filter circuits described above, bandpass filtering to transmit only around the readout frequency of the readout-resonator and notch filtering to suppress energy relaxation of the qubit into the observation line.

Yet another aspect of the disclosure is a method of dispersive readout of a qubit to an observation line. This method comprises one of the filter circuits described above, coupling the electromagnetic field mode of the qubit to the electromagnetic field mode of the readout-resonator and coupling the readout-resonator to the observation line.

Any combination of the above components, and any conversion of the expressions of the present disclosure between methods, devices, systems, recording media, computer programs, etc., is also valid as an aspect of the present disclosure.

ADVANTAGEOUS EFFECTS OF INVENTION

According to the present disclosure, it is possible to realize a filter circuit that has both a bandpass filter function that transmits only around the readout frequency of the readout-resonator and a notch filter function that suppresses energy relaxation of the qubits into the observation line.

BRIEF DESCRIPTION OF DRAWINGS

[FIG. 1] Fig. 1 is a schematic diagram of a filter circuit according to the first embodiment.
[FIG. 2] Fig. 2 is a schematic diagram of a filter circuit that is an example of the filter circuit of Fig. 1.
[FIG. 3] Fig. 3 is a schematic diagram of a filter circuit that is another example of the filter circuit of Fig. 1.
[FIG. 4] Fig. 4 is a schematic diagram of yet another filter circuit according to the first embodiment.
[FIG. 5] Fig. 5 shows an example implementation of the filter circuit of Fig. 4.
[FIG. 6] Fig. 6 is a schematic diagram of yet another filter circuit according to the first embodiment.
[FIG. 7] Fig. 7 is a schematic diagram of a quantum device according to the second embodiment.
[FIG. 8] Fig. 8 shows the frequency characteristics of the transmitted signal of the filter circuit of Fig. 2.
[FIG. 9] Fig. 9 shows the radiation relaxation lifetime of a qubit obtained by simulation.
[FIG. 10] Fig. 10 shows an example implementation of a filter circuit with intrinsic notches used for 4 multiple readouts of superconducting qubits.
[FIG. 11] Fig. 11 shows an enlarged view of the area near the first qubit in Fig. 10.
[FIG. 12] Fig. 12 shows the frequency dependence of the radiation relaxation time for the first qubit.
[FIG. 13] Fig. 13 shows the frequency dependence of the radiation relaxation time for the second qubit.
[FIG. 14] Fig. 14 shows the frequency dependence of the radiation relaxation time for the third qubit.
[FIG. 15] Fig. 15 shows the frequency dependence of the radiation relaxation time for the fourth qubit.
[FIG. 16] Fig. 16 is a schematic diagram of a multiconductor transmission line.

DESCRIPTION OF EMBODIMENTS

The first embodiment

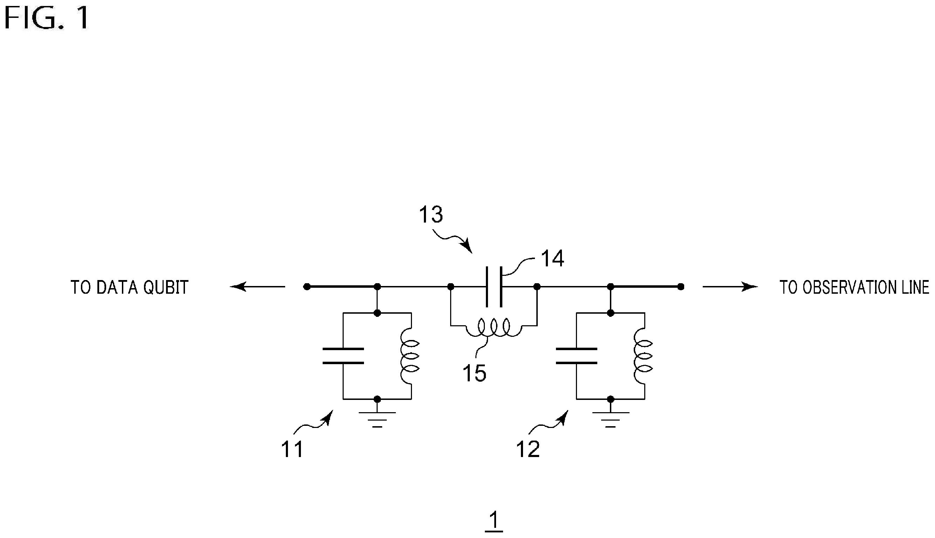

Figure 1 schematically shows a filter circuit 1 according to the first embodiment. The filter circuit 1 comprises a readout-resonator 11 and a filter-resonator 12. The readout-resonator 11 is coupled to an external data qubit. The filter-resonator 12 couples to an external observation line. The readout-resonator 11 and the filter-resonator 12 are electro-magnetically coupled to each other using capacitive coupling and inductive coupling in parallel. Filter resonator 12 is a bandpass filter that transmits around the readout frequency of readout-resonator 11 and functions as an individual filter-resonator.

An intrinsic notch filter can be realized by electromagnetically coupling a pair of resonators that comprise the readout-resonator 11 and the filter-resonator 12, using capacitive coupling and inductive coupling in parallel. Hereafter, such a circuit model in which pairs of resonators are electromagnetically coupled to each other using capacitive coupling and inductive coupling in parallel is referred to as a "concentrated constant circuit model."

The principle of operation of this embodiment is explained below. The impedance of the coupler circuit 13 becomes infinite at the resonant frequency $\omega_f = 1/\sqrt{(C_f L_f)}$, where the capacitive coupling and inductive coupling of the above coupled circuit are $C_f$ and $L_f$, respectively. Therefore, at this frequency, the readout-resonator 11 and the filter-resonator 12 behave as separated circuits. As a result, signal transmission from the data qubit to the observation line is inhibited, and the circuit functions as a stopband filter as a whole. At the frequency of the readout-resonator 11, the impedance of the coupling circuit is finite, therefore the coupling between the readout-resonator 11 and the observation line remains. This allows the filter-resonator 12, i.e., the individual parcel filter circuit, to discriminate the readout-resonator frequency while simultaneously configuring the circuit with a stopband by means of an electro-magnetic coupling circuit.

An example of an implementation of this embodiment is the intrinsic addition of a notch filter that performs the function of a notch filter at the qubit frequency. In this case, the inductive coupling of the coupler circuit 13 is realized by the mutual inductance of the readout-resonator 11 and the filter-resonator 12. According to this example, there is no need to add any special hardware other than the readout-resonator 11 and the filter-resonator 12, and the bandpass-like readout frequency filtering by the original individual parcel filter, i.e., filter-resonator 12, can be utilized as is to provide the notch function. As a result, the readout-resonator can be used as a notch. As a result, even when the readout-resonator is more strongly coupled to the observation line, it is possible to suppress the relaxation of the qubit and achieve high-speed readout. The present disclosure can improve the function of qubit relaxation suppression, which was insufficient in conventional bandpass individual parcel filters.

Furthermore, this embodiment allows the desired filter characteristics to be added without increasing the physical circuit area. In other words, in conventional techniques, additional circuit area was required to obtain additional filter performance. On the other hand, this intrinsic implementation technique solves this problem and facilitates the integration of superconducting qubit chips.

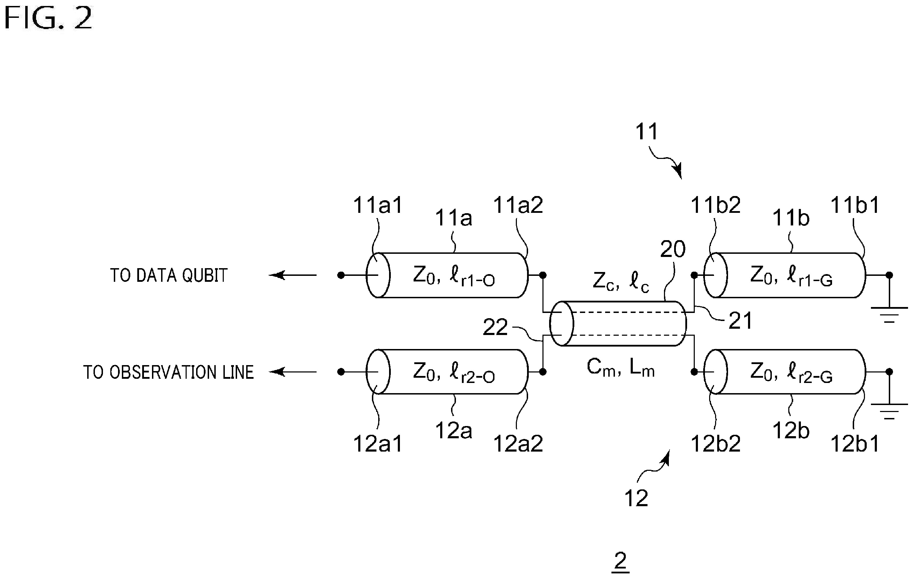

Figure 2 schematically shows the filter circuit 2 as a specific example of the circuit in Figure 1. The filter circuit 2 comprises a readout-resonator 11, a filter-resonator 12 and a multiconductor transmission line 20. In the example of Fig. 2, the readout-resonator 11 and the filter-resonator 12 both comprise a quarter-wavelength resonator.

The readout-resonator 11 of the filter circuit 2 comprises a first readout-resonator section 11a and a second readout-resonator section 11b. The first readout-resonator section 11a comprises a first end 11a1 and a second end 11a2. The second readout-resonator section 11b comprises a first end 11b1 and a second end 11b2. The first end 11a1 of the first readout-resonator section 11a of the readout-resonator 11 is connected to a data qubit. The first end 11b1 of the second readout-resonator section 11b of the readout-resonator 11 is grounded.

The filter-resonator 12 of the filter circuit 2 comprises a first filter-resonator section 12a and a second filter-resonator section 12b. The first filter-resonator section 12a comprises a first end 12a1 and a second end 12a2. The second filter-resonator section 12b comprises a first end 12b1 and a second end 12b2. The first end 12a1 of the first filter-resonator section 12a of the filter-resonator 12 is connected to an observation line. The first end 12b1 of the second filter-resonator section 12b of the filter-resonator 12 is grounded.

The multiconductor transmission line 20 comprises a first conductor wire 21 and a second conductor wire 22. The multiconductor transmission line 20 is situated in between the readout-resonator 11 and the filter-resonator 12. More specifically, the first conductor wire 21 of the multiconductor transmission line 20 connects the second end 11a2 of the first readout-resonator section 11a and the second end 11b2 of the second readout-resonator section 11b of the readout-resonator 11. The second conductor wire 22 of the multiconductor transmission line 20 connects the second end 12a2 of the first filter-resonator section 12a of the filter-resonator 12 and the second end 12b2 of the second filter-resonator section 12b of filter-resonator 12. In this way, the multiconductor transmission line 20 is situated in between the second end 11a2 of the first readout-resonator section 11a of the readout-resonator 11 and the second end 12a2 of the first filter-resonator section 12a of the filter-resonator 12, and, the second end 11b2 of the second readout-resonator section 11b of the readout-resonator 11 and the second end 12b2 of the second filter-resonator section 12b of the filter-resonator 12. In this configuration, the mutual inductance between the first conductor wire 21 and the second conductor wire 22 in the multiconductor transmission line is used to obtain magnetic coupling.

According to this example, a multiconductor transmission line can be used to realize an intrinsic notch filter circuit.

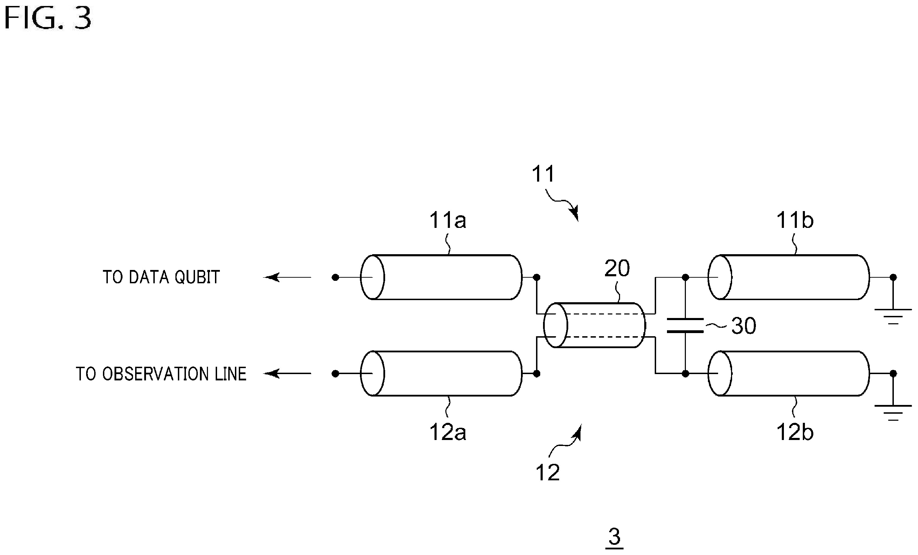

Figure 3 schematically shows a filter circuit 3 as another specific example of the circuit in Figure 1. Filter circuit 3 comprises a shunt capacitor 30 between the conductors adjacent to the multiconductor transmission line 20, in addition to the configuration of filter circuit 2 in Figure 2. This configuration also utilizes the multiconductor transmission line 20 to obtain magnetic coupling. This configuration utilizes the capacitance of the multiconductor transmission line 20 and the shunt capacitor 30 to obtain electrical coupling. The addition of the shunt capacitor 30 can be used to address the insufficient capacitance of the multiconductor transmission line or the need to adjust the electrical coupling individually.

Next, it is explained that the distributed constant circuit configuration shown in Figure 2 can be used to reproduce the concentrated constant circuit model of Figure 1. Using multiconductor transmission line analysis, see, for example, Non-Patent Literature 7, we map the parameters of this distributed circuit to the parameters of the concentrated constant circuit of Fig. 1. This shows that both circuits have the same electrical response with high accuracy over the desired frequency range. Furthermore, we show that desirable values for the parameters of the distributed constant circuit can be achieved using a multiconductor transmission line of the appropriate physical size for superconducting quantum circuits.

First, we define the basic transmission line quantities. The behavior of a lossless transmission line can be described by the capacitance $C_l$ to ground to ground per-unit-length and the inductance $L_l$ to ground per-unit-length.

Equivalently, it can also be described by the characteristic impedance $Z_0$ and the phase velocity v.
[Equation 1]

$$Z_0 = \sqrt{\frac{L_l}{C_l}} \text{ and } v = \frac{1}{\sqrt{L_l C_l}} \qquad (0)$$

A transmission line of total length l with one end grounded has a fundamental resonant frequency $\omega_r = 2\pi/\lambda$, where A/4 = l. Around this resonant frequency, the transmission line can be modeled as a concentrated constant LC resonator. In this case, the effective capacitance C and inductance are given by the following expression.
[Equation 2]

$$C = C_l \ell/2 \, , \; L = 8L_l \ell/\pi^2 \qquad (1)$$

In contrast to a single-conductor transmission line, a multiconductor transmission line has n conductor lines and one ground reference point. For a lossless two-conductor transmission line, this line is described by the following six parameters, viz,

capacitance to ground per-unit-length of conductor line 1: $C_{l,1}$,
capacitance to ground per-unit-length of conductor line 2: $C_{l,2}$,
inductance to ground per-unit-length of conductor line 1: $L_{l,1}$,
inductance to ground per-unit-length of conductor line 2, $L_{l,2}$,
capacitance per-unit-length between the two conductor lines: $C_m$,
inductance per-unit-length between the two conductor lines: $L_m$.

In Figure 2, the capacitance to ground per-unit-length and inductance to ground per-unit-length are assumed to be the same for all conductor lines. Also, $C_l >> C_m$ is assumed, which corresponds to the case where the two conductor lines of a multi-conductor transmission line are weakly coupled, i.e., weak coupling assumption, hereinafter also referred to as "weak coupling approximation." This assumption is valid when the signal leaking out to the other conductor is negligibly small compared to the signal propagating through each conductor in the multi-conductor transmission line, and when the perturbation effect due to coupling is small, which is the case for typical coupling strengths in superconducting quantum circuit applications, see, for example, Non-Patent Literature 8. Even under these assumptions, the resonance frequency $\omega_f$ of the notch filter can be obtained analytically.

If the above assumptions hold, the first readout-resonator section 11a, the second readout-resonator section 11b and the multiconductor transmission line 20 of the readout-resonator 11 operate as a single conductor transmission line of total length $l_{r1-0} + l_c + l_{r1-G}$. The line is grounded at one end and $\lambda/4$ resonates at A/4 = $l_{r1-0} + l_c + l_{r1-G}$.

Similarly, the first filter-resonator section 12a, the second filter-resonator section 12b and the multiconductor transmission line 20 of the filter-resonator 12 operate as a single conductor transmission line of total length $l_{r2-0} + l_c + l_{r2-G}$. This line A/4 resonates at A/4 = $l_{r2-0} + l_c + l_{r2-G}$. Then, Equation (1) gives a mapping to the capacitance and the inductance of the two grounded LC resonators in Figure 2.

From the above, Equation (1) gives a mapping to the capacitance and the inductance of the two grounded LC resonators in Figure 1.

To find the mapping to the coupling capacitance $C_f$ and the coupling inductance $L_f$, we first find the frequency at which the transfer impedance $Z_{12}$ between the data qubit node and the detector node in the circuit of Fig. 2 is zero. This frequency relates the lowest frequency solution to the frequency $\omega_f = 1/\sqrt{(C_f L_f)}$ by assuming that the transfer impedance $Z'_{12}$ of the concentrated constant equivalent circuit in Figure 1 also goes to zero.

Next, we find the impedance $Z_f = \sqrt{(L_f/C_f)}$ of the coupled circuit element in Figure 1. This satisfies the following equation:
[Equation 3]

$$Z_f = \frac{2iZ_{r1}(\omega_f)Z_{r2}(\omega_f)}{\omega_f} \left[\frac{dZ'_{12}}{d\omega}\Big|_{\omega=\omega_f}\right]^{-1} \qquad (2)$$

, where $Z_{r1}(\omega_f)$ and $Z_{r2}(\omega_f)$ are the impedances of the centralized constant resonators r1 and r2 evaluated at frequency $\omega_f$, respectively. To find $Z_f$ using the circuit in Figure 2, we map the right-hand side of this equation to the circuit in Figure 2. The capacitance and the inductance of the centralized constant resonators r1 and r2, respectively, are obtained using Equation (1). Assuming that the transfer impedance $Z'_{12}$ of the concentrated constant equivalent circuit behaves like the transfer impedance $Z_{12}$ of the distributed constant circuit in Figure 2 near the resonant frequency, we substitute $Z'_{12}$ for $Z_{12}$. This allows the right-hand side to be described only by the parameters of the circuit in Figure 2.

Since the capacitance $C_m$ and the inductance $L_m$ are completely determined by the frequency $\omega_f$ and impedance $Z_f$, this completes the mapping between the circuit in Figure 1 and the circuit in Figure 2.

If the multiconductor transmission line can be weakly coupling approximated, the analytical expression for the notch frequency $\omega_f$ can be obtained as follows. For example, referring to Non-Patent Literature 8, the analytical expression for the transfer impedance $Z_{12}$ under the assumption of weak coupling can be obtained. Here, each variable is defined as follows.

[Equation 4]

$$\tilde{\tau}_1 = \frac{\ell_{r1-G}}{v} + \frac{\ell_c}{2v_c}, \ \ \tilde{\tau}_2 = \frac{\ell_{r2-G}}{v} + \frac{\ell_c}{2v_c}, \ \ v_c = \frac{1}{\sqrt{L_l(C_l+C_m)}}, \ \ Z_c = \sqrt{\frac{L_l}{C_l+C_m}}, \ \ Z_m = \sqrt{\frac{L_m}{C_m}} \qquad (3)$$

For the case where the transfer impedance is zero, we obtain the following equation for the notch frequency $\omega_f$.

[Equation 5]

$$\frac{1}{sinc(\omega_f\ell_c/v_c)}\left[\frac{\cos(2\omega_f\tilde{\tau}_1)+\cos(2\omega_f\tilde{\tau}_2)}{1+\cos(2\omega_f[\tilde{\tau}_1+\tilde{\tau}_2])}\right] = \frac{Z_c^2+Z_m^2}{Z_c^2-Z_m^2} \qquad (4)$$

Namely, the notch frequency $\omega_f$ of the filter circuit 2 in Figure 2 is determined to satisfy the following equation:

[Equation 5]

$$\frac{1}{sinc(\omega_f\ell_c/v_c)}\left[\frac{\cos(2\omega_f\tilde{\tau}_1)+\cos(2\omega_f\tilde{\tau}_2)}{1+\cos(2\omega_f[\tilde{\tau}_1+\tilde{\tau}_2])}\right] = \frac{Z_c^2+Z_m^2}{Z_c^2-Z_m^2} \qquad (4)$$

, where the length of the multiconductor transmission line 20 is $l_c$,

where the propagation velocity of the wave propagating through the multiconductor transmission line 20 is $v_c$,

where the capacitance to ground per-unit-length of the first conductor 21 and the second conductor 22 of the multiconductor transmission line 20 are $C_l$,

where the inductance to ground per-unit-length of the first conductor 21 and the second conductor 22 of the multiconductor transmission line 20 are $L_l$,

where the capacitance to ground per-unit-length between the first conductor 21 and the second conductor 22 of the multiconductor transmission line 20 is $C_m$,

where the inductance per-unit-length between the first conductor 21 and the second conductor 22 of the multi-conductor transmission line 20 is $L_m$,

where the length of the second readout-resonator section 11b of the readout-resonator 11 is $l_{r1-G}$,

where the length of the second filter-resonator section 12b of the filter-resonator 12 is $l_{r2-G}$,

where the length of the multiconductor transmission line 20 is $l_c$ and

where the variables of the distributed constant circuit are:

[Equation 4]

$$\tilde{\tau}_1 = \frac{\ell_{r1-G}}{v} + \frac{\ell_c}{2v_c}, \ \ \tilde{\tau}_2 = \frac{\ell_{r2-G}}{v} + \frac{\ell_c}{2v_c}, \ \ v_c = \frac{1}{\sqrt{L_l(C_l+C_m)}}, \ \ Z_c = \sqrt{\frac{L_l}{C_l+C_m}}, \ \ Z_m = \sqrt{\frac{L_m}{C_m}} \qquad (3)$$

According to this embodiment, the filter circuit can be realized in a system of a multiconductor transmission line approximated by weak coupling, with the parameters specifically defined.

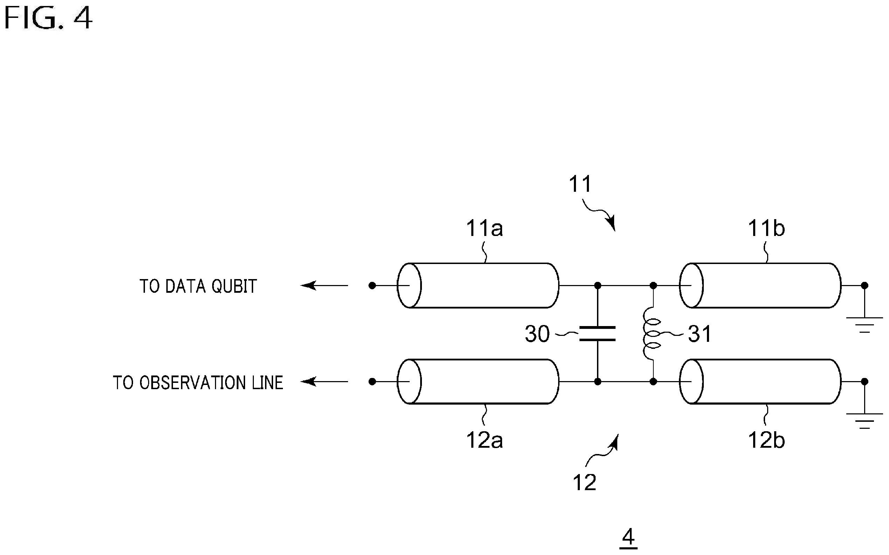

Figure 4 schematically shows yet another filter circuit 4 of the first embodiment. The filter circuit 4 comprises a readout-resonator 11, a filter-resonator 12, a capacitor 30 and an inductor 31. The readout-resonator 11 comprises a first readout-resonator section 11a and a second readout-resonator section 11b. The filter-resonator 12 comprises a first filter-resonator section 12a and a second filter-resonator section 12b. The capacitor 30 and the inductor 31 are situated in between the first readout-resonator section 11a and the first filter-resonator section 12a, and, the second readout-resonator section 11b and the second filter-resonator section 12b. In other words, the filter circuit 4 comprises the capacitor 30 and the inductor 31 instead of the multiconductor transmission line 20 of the filter circuit 2 in Figure 2. The other components of the filter circuit 4 are the same as those of the filter circuit 2. Capacitive coupling and inductive coupling between the readout-resonator 11 and the filter-resonator 12 are realized by the capacitor 30 and inductor 31, respectively.

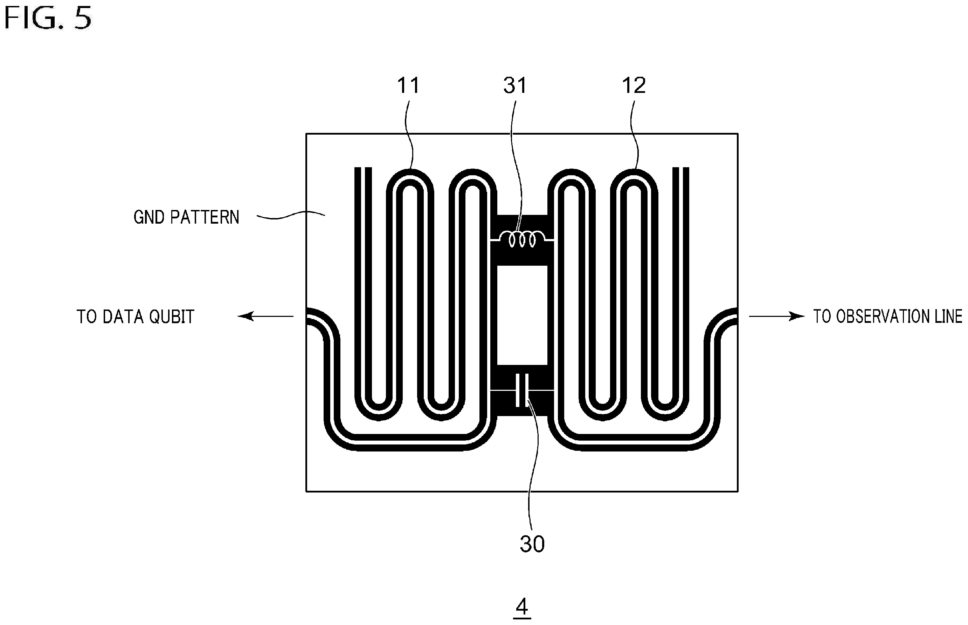

Figure 5 shows an example implementation of the filter circuit 4 of Figure 4.

According to this embodiment, a filter circuit that achieves the desired function can be fabricated using capacitors and inductors as circuit elements.

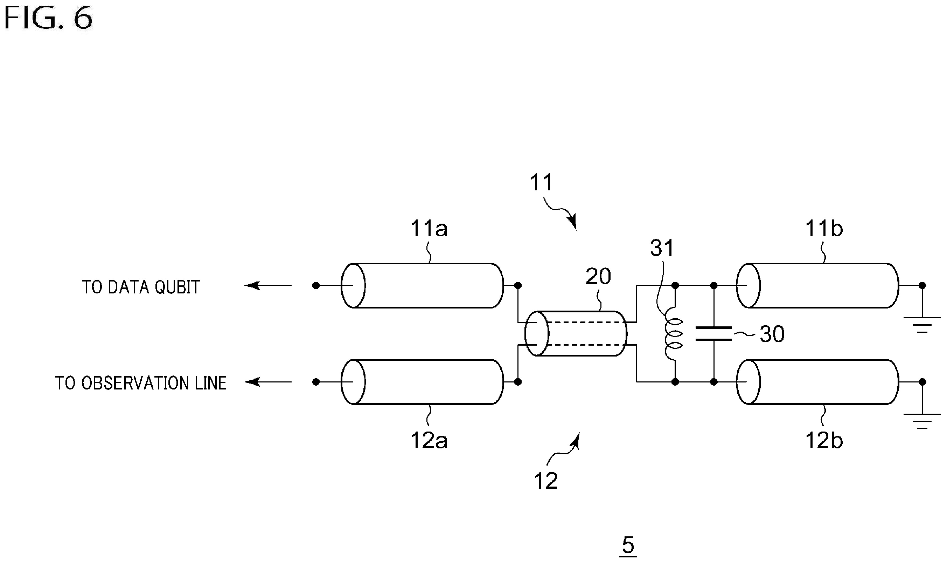

Figure 6 schematically shows yet another filter circuit 5 of the first embodiment. The filter circuit 5 comprises a readout-resonator 11, a filter-resonator 12, a multiconductor transmission line 20, a capacitor 30 and an inductor 31. The multiconductor transmission line 20 is situated in between the readout-resonator 11 and the filter-resonator 12. The capacitor 30 and the inductor 31 are situated adjacent to the multiconductor transmission line 20.

The filter circuit 5 has a structure that combines the filter circuit 2 of Fig. 2 and the filter circuit 4 of Fig. 4. Capacitive coupling and inductive coupling between the readout-resonator 11 and the filter-resonator 12 is realized by the multiconductor transmission line 20, the capacitor 30 and the inductor 31.

According to this example, the degree of freedom of configuration can be increased.

Additional Example

In the previous example, the notch frequency $\omega_f$ of the filter circuit 2 in Figure 2 was implicitly expressed by Equation (4). However, in many practical cases, it is easier to use the notch frequency if it is explicitly expressed. In the following, such examples are described.

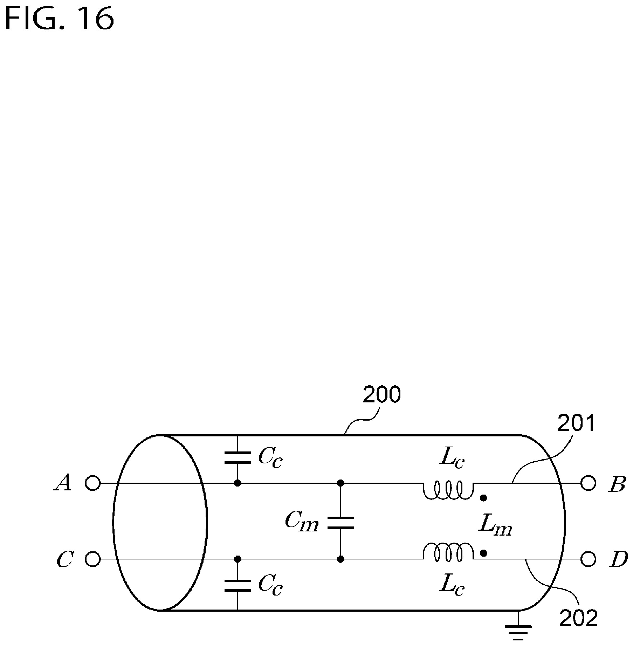

Hereafter, instead of the multiconductor transmission line 2 of Fig. 2, the multiconductor transmission line 200 of Fig. 16 shall be used. Assume that the capacitance to ground per-unit-length of the multiconductor transmission line 200 is $C_C$, the inductance to ground per-unit-length of the multiconductor transmission line 200 is $L_C$, the capacitance per-unit-length between the first conductor line 201 and the second conductor line 202 of the multiconductor transmission line 200 is $C_m$, and the inductance per-unit-length between the first conductor line 201 and the second conductor line 202 of the multiconductor transmission line 200 is $L_m$. Then the notch frequency $\omega_f$ of the filter circuit using the multiconductor transmission line 200 in Figure 16 is determined to satisfy the following equation:

[Equation 7]

$$\frac{1}{sinc(\omega_f \ell_c / v_{0c})} \left[ \frac{\cos(2\omega_f \tilde{\tau}_1) + \cos(2\omega_f \tilde{\tau}_2)}{1 + \cos(2\omega_f [\tilde{\tau}_1 + \tilde{\tau}_2])} \right] = \frac{z_{0c}^2 + z_{0m}^2}{z_{0c}^2 - z_{0m}^2} \qquad (6)$$

, where the variables of the distributed constant circuit are the following.

[Equation 6]

$$v_{0c} = \frac{1}{\sqrt{L_c(C_c + C_m)}}, \qquad Z_{0c} = \sqrt{\frac{L_c}{C_c + C_m}}, \qquad (5)$$

For a multiconductor transmission line in a uniform medium or a multiconductor transmission line of which top and bottom geometry is symmetrical and each consists of a uniform medium, for example, a multiconductor coplanar line, the following approximate equation holds with very good accuracy.

[Equation 8]

$$Z_{0c}^2 = Z_{0m}^2 \qquad (7)$$

This is because a multiconductor transmission line with coupled conductors behaves like a multiconductor transmission line in a homogeneous medium, except in extreme cases where the geometry is asymmetric.

From Equation (6) and Equation (7), the following holds.

[Equation 9]

$$1 + \cos(2\omega_f [\tilde{\tau}_1 + \tilde{\tau}_2]) = 0 \qquad (8)$$

Thus, the notch frequency $\omega_f$ can be explicitly expressed as follows.

[Equation 10]

$$\omega_f = \frac{\pi}{2(\tilde{\tau}_1 + \tilde{\tau}_2)} \qquad (9)$$

According to this embodiment, the notch frequency can be explicitly expressed, which allows for greater freedom in the design and practical use of the filter circuit.

Equation (7) further gives the following explicit expression for the J, i.e., J coupling constant, between the readout-resonator and the filter-resonator.

[Equation 11]

$$J = \overline{\omega}_{rp} \frac{\pi^2}{32} \frac{\left(\dfrac{\overline{\omega}_{rp}}{\omega_f} - \dfrac{\omega_f}{\overline{\omega}_{rp}}\right)}{\cos\left(\dfrac{\pi\omega_f}{2\overline{\omega}_{rp}}\right)} \left(\frac{C_m}{C_c + C_m}\right) \sin\left(\frac{\omega_f \ell_c}{v_c}\right) \qquad (10)$$

The coupling constant J is a constant that expresses the strength of the coupling, determined by the following interaction Hamiltonian $H_{int}$.

[Equation 12]

$$H_{int} = \hbar_J \left( \hat{a}_r^\dagger \hat{a}_p + \hat{a}_r \hat{a}_p^\dagger \right) \qquad (11)$$

Here, :

[Equation 13]

$$\hat{a}_r^\dagger$$

is the creation operator of the readout-resonator,:

[Equation 14]

$$\hat{a}_p^\dagger$$

is the creation operator of the filter-resonator,:

[Equation 15]

$$\hat{a}_r$$

is the annihilation operator of the readout-resonator and:

[Equation 16]

$$\hat{a}_p$$

is the annihilation operator of the filter-resonator. Furthermore, each variable in equation (10) is defined as follows.

[Equation 17]

$$\overline{\omega}_{rp} = \frac{\omega_r + \omega_p}{2}$$

[Equation 18]

$$\omega_r = \frac{\pi v}{2\left(\ell_{r1-o} + \ell_c + \ell_{r1-G}\right)}$$

[Equation 19]

$$\omega_p = \frac{\pi v}{2\left(\ell_{r2-o} + \ell_c + \ell_{r2-G}\right)}$$

According to this embodiment, it is possible to improve the degree of freedom in the design and practical use of filter circuits because the degree of freedom of the coupling can be explicitly expressed.

The second embodiment

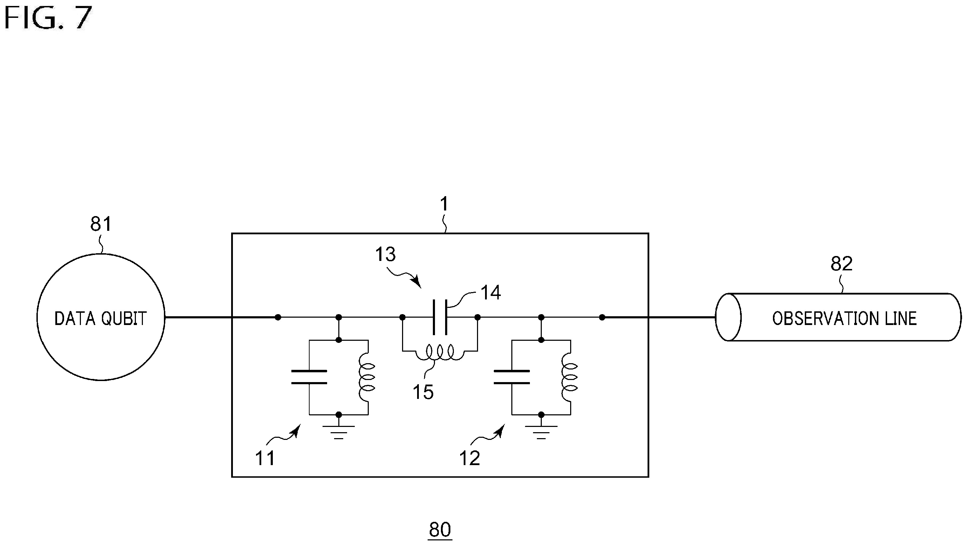

Figure 7 schematically shows a quantum device 80 according to the second embodiment. The quantum device 80 comprises a data qubit 81, an observation line 82 and a filter circuit 1.
The filter circuit 1 comprises a readout-resonator 11 and a filter-resonator 12. The readout-resonator 11 couples to the external data qubit. The filter-resonator 12 couples to the external observation line. The readout-resonator 11 and the filter-resonator 12 are electromagnetically coupled to each other using capacitive coupling and inductive coupling in parallel. The filter-resonator 12 is a bandpass filter that transmits around the readout frequency of readout-resonator 11 and functions as an individual filter-resonator.
The readout-resonator 11 couples to the data qubit 81 and reads out the state of the data qubit 81. The observation line 82 couples to the readout-resonator 11 and transmits the information of the data qubit 81 read out by the readout-resonator 11 to an observation device.
As mentioned above, in the filter circuit 1, the readout-resonator 11 and the filter-resonator 12 are electromagnetically and magnetically coupled in parallel using capacitive coupling and inductive coupling to achieve a notch filter. Other details of the operation and effects of the filter circuit 1 are as described above.
According to this embodiment, a quantum device can be realized using a filter circuit that has both a bandpass filter function that transmits only around the readout frequency of the readout-resonator and a notch filter function that suppresses the relaxation of qubits into the observation line.
The quantum device 80 of FIG. 7 can also be considered as a filter circuit as follows. That is, this filter circuit 80 comprises one or more data qubits 81, one or more readout-resonators 11 corresponding to each of these data qubits, one or more filter-resonators 12 having a characteristic corresponding to the resonant frequency of the readout-resonators, a coupler circuit 13 and a common observation line 82. The coupler circuit 13 is situated in between the readout-resonators and the filter-resonators, and magnetically couples the readout-resonators and the filter-resonators. The filter circuit 80 has both bandpass filter characteristics near the readout frequency using the resonance of the filter-resonator 12, and notch filter characteristics near the qubit frequency using interference in the electrical and magnetic coupler circuit.

The third embodiment

The third embodiment is a quantum computer. This quantum computer comprises the quantum device of the second embodiment.
According to this embodiment, a quantum computer can be realized using a filter circuit that has both a bandpass filter function that transmits only around the readout frequency of the readout-resonator and a notch filter function that suppresses relaxation of the qubits into the observation line.

The fourth embodiment

The fourth embodiment is a method of manufacturing a filter circuit. This method comprises a step S1 of forming a readout-resonator, a step S2 of forming a filter-resonator, a step S3 of coupling the readout-resonator to a data qubit, a step S4 of coupling the filter-resonator to an observation line and a step S5 of electro-magnetically coupling the readout-resonator to the filter-resonator using capacitive coupling and inductive coupling in parallel.

According to this embodiment, it is possible to manufacture a filter circuit that has both a bandpass filter function that transmits only around the readout frequency of the readout-resonator and a notch filter function that suppresses energy relaxation of the qubits into the observation line.

The fifth embodiment

The fifth embodiment is a method for assembling a filter circuit. This method comprises a step S11 of providing a readout-resonator component to be coupled with a data qubit, a step S12 of providing a filter-resonator component to be coupled with an observation line and a step S13 of assembling the readout-resonator component and the filter-resonator component to be electromagnetically coupled to each other using capacitive coupling and inductive coupling in parallel.

According to this embodiment, it is possible to assemble a filter circuit combining the readout-resonator component with the filter-resonator component. In addition, it is possible to inspect, repair, replace, etc. the readout-resonator component and filter-resonator component, component by component.

The sixth embodiment

The sixth embodiment is a method of filtering the readout frequency in dispersive readout of a qubit to an observation line. The method comprises a step S22 of bandpass filtering to transmit only around the readout frequency of the readout-resonator and a step S23 of notch filtering to suppress energy relaxation of the qubit into the observation line, using one of the filter circuits described above.

According to this embodiment, the coupling between the readout-resonator and the observation line can be maintained while suppressing the relaxation of the qubit to the observation line when the qubit is dispersive readout to the observation line.

Seventh embodiment.

The seventh embodiment is a method of dispersive readout of a qubit. The method comprises a step S31 of coupling the electromagnetic field mode of the qubit to the electromagnetic field mode of the readout-resonator and a step S32 of coupling the readout-resonator to the observation line, using one of the filter circuits described above.

According to this embodiment, the parcel effect can be suppressed, and dispersive readout of a qubit can be performed.

The present disclosure has been described based on some embodiments. It is understood by those skilled in the art that these embodiments are merely examples and that various variations are possible in the combination of each of its components and each of its processing processes, and that such variations are also within the scope of this disclosure.

Verification

The inventors have conducted the following verification to confirm the validity of the above described embodiments.

First, the accuracy of the above mapping was verified by comparing the transfer impedances of these circuits over the frequency range used for superconducting circuit applications. The parameter values used in the simulations are listed in Table 1.

[Table 1]

| $Z_0$ (Ω) | $v$ (m/s) | $\ell_c$ (um) | $\ell_{r1-O}$ (um) | $\ell_{r1-G}$ (um) | $\ell_{r2-O}$ (um) | $\ell_{r2-G}$ (um) | $L_m$ (nH/m) | $C_m$ (fF/m) |
|---|---|---|---|---|---|---|---|---|
| 65 | $1.2 \times 10^8$ | 800 | 1440 | 2720 | 2320 | 1840 | 3.96 | 40 |

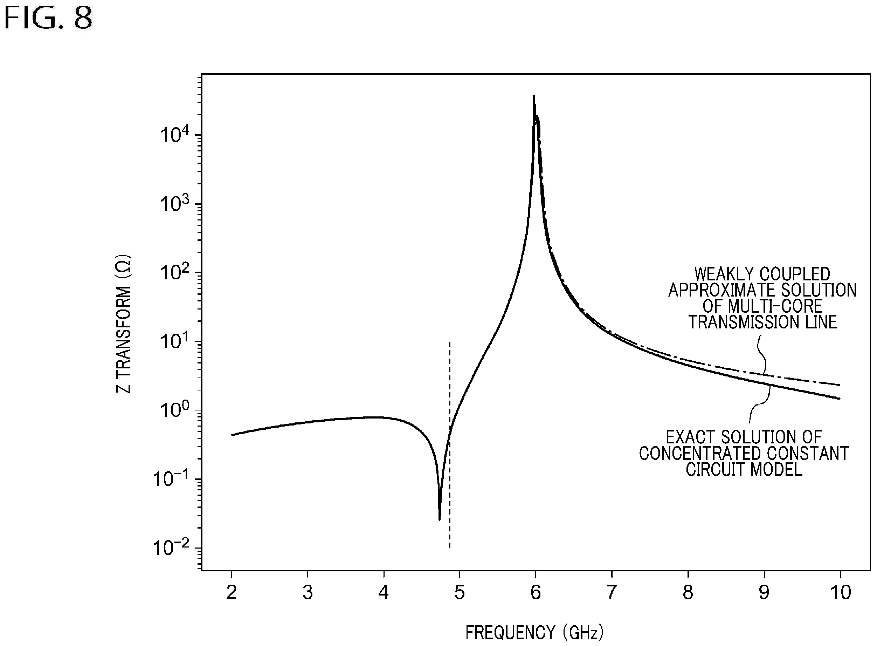

Figure 8 shows the frequency response of the transmitted signal from the port labeled "TO DATA QUBIT" to the port labeled "TO OBSERVATION LINE" in Figure 2. Figure 8 shows the exact solution of the concentrated constant circuit model in Figure 1 (solid line) and the weakly coupled approximate solution of the multiconductor transmission line in Figure 2 (dotted line). The frequency characteristics of both are in good agreement. Furthermore, it can be seen that the assumption of weak coupling is sufficiently valid in the parameter region typically used for reading out superconducting qubits. The vertical dashed line indicates the notch frequency obtained from Equation (4). It can be seen that the notch frequency is in good agreement with the frequency of the analytical solution.

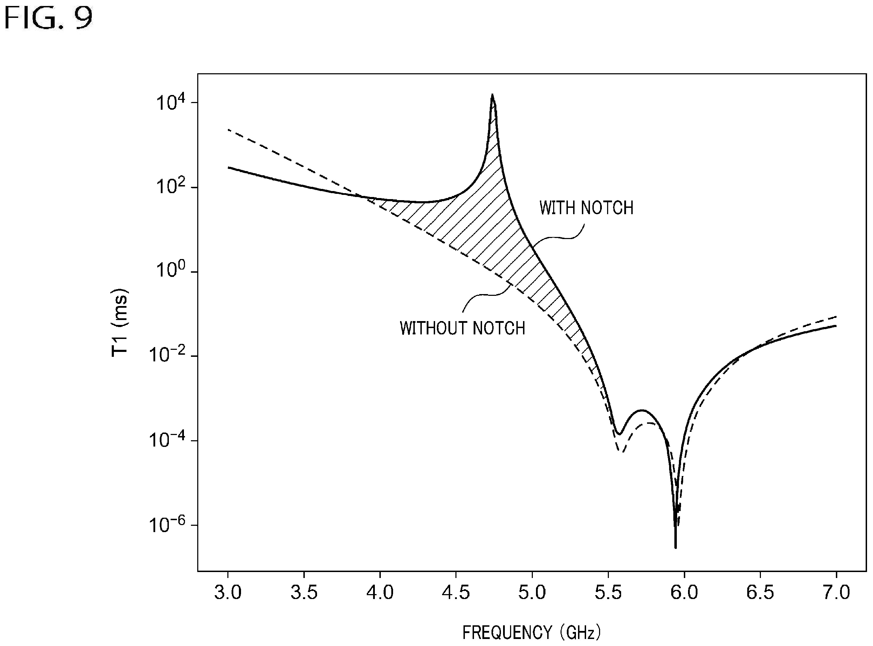

Figure 9 shows the radiation relaxation lifetime of the qubit obtained from the simulation. The parameters of the circuit used are as follows. That is, qubit frequency $f_{qub}$ = 4.75 GHz, readout-resonator frequency $f_{res}$ = 6 GHz, readout-resonator external coupling strength/$2\pi$ = 50 MHz, coupling between qubit and readout-resonator g = 125 MHz, coupling between readout-resonator and filter-resonator J = 30 MHz. In Figure 9, the qubit lifetimes in a circuit containing an intrinsic notch filter (WITH NOTCH) and in a readout circuit with only an individual parcel filter (WITHOUT NOTCH) are compared for the same coupling constant.

As shown in Fig. 9, it can be seen that, with the use of a notch, a sufficiently longer lifetime can be achieved in this circuit than in a conventional circuit with an individual parcel filter at qubit frequencies above 4 GHz.

In order to optimally utilize the function of notch filtering in this embodiment, the frequency of the notch filter must be adjusted close enough to the qubit frequency. With a sufficient number of the degrees of freedom of the parameter for optimization, it is possible to adjust only the notch filter frequency while maintaining the readout-resonator frequency and the coupling strength between the readout-resonator and the filter-resonator.

Next, we describe an experimental technique of realizing the distributed constant circuit shown in Fig. 2. As shown below, by experimentally realizing a filter circuit in the configuration shown in Figure 2, the notch filter of the disclosure can be implemented in an intrinsic form.

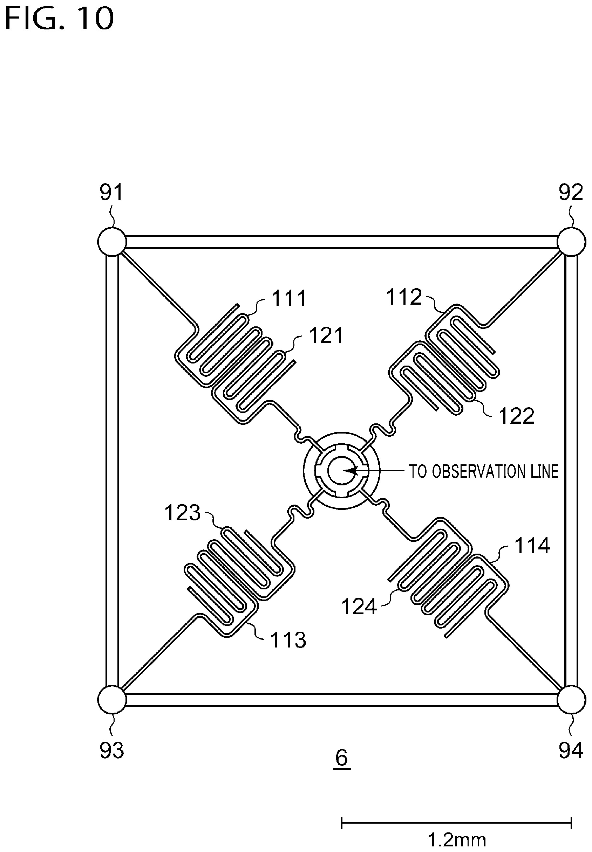

Figure 10 shows an example implementation of a filter circuit 6 with an intrinsic notch used for quadruple readout of a superconducting qubit. The filter circuit 6 comprises a first readout-resonator 111, a second readout-resonator 112, a third readout-resonator 113, a fourth readout-resonator 114, a first filter-resonator 121, a second filter-resonator 122, a third filter-resonator 123 and a fourth filter-resonator 124. The first readout-resonator 111 couples to the first qubit 91. The second readout-resonator 112 couples to the second qubit 92. The third readout-resonator 113 couples to the third qubit 93. The fourth readout-resonator 114 couples to the fourth qubit 94. The first filter-resonator 121, the second filter-resonator 122, the third filter-resonator 123 and the fourth filter-resonator 124 couple to one common observation line.

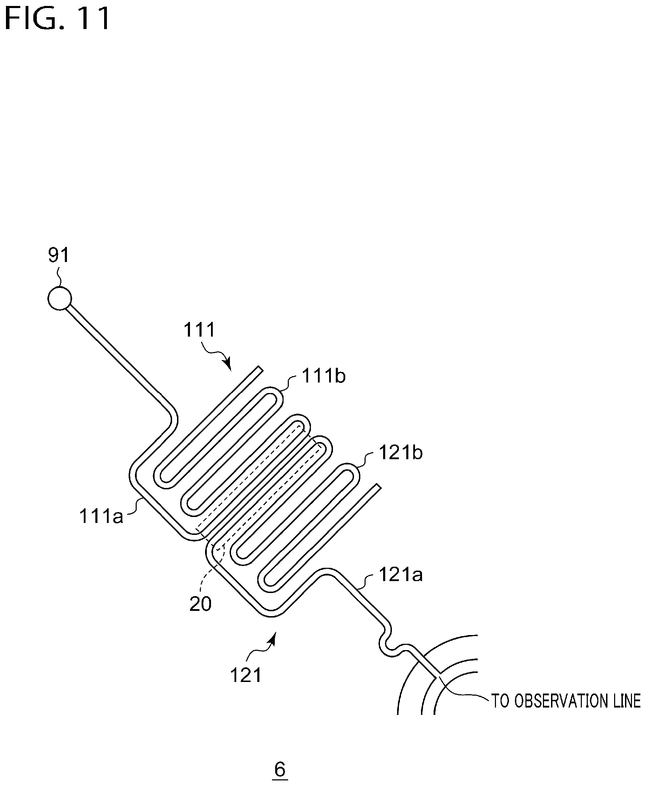

Figure 11 is an enlarged view of Figure 10, near the first qubit 91. The first readout-resonator 111 comprises a first readout-resonator section 111a and a second readout-resonator section 111b. The first filter-resonator 111 comprises a first filter-resonator section 121a and a second filter-resonator section 121b. A multiconductor transmission line 20 is situated in between the first readout-resonator 111 and the first filter-resonator 112.

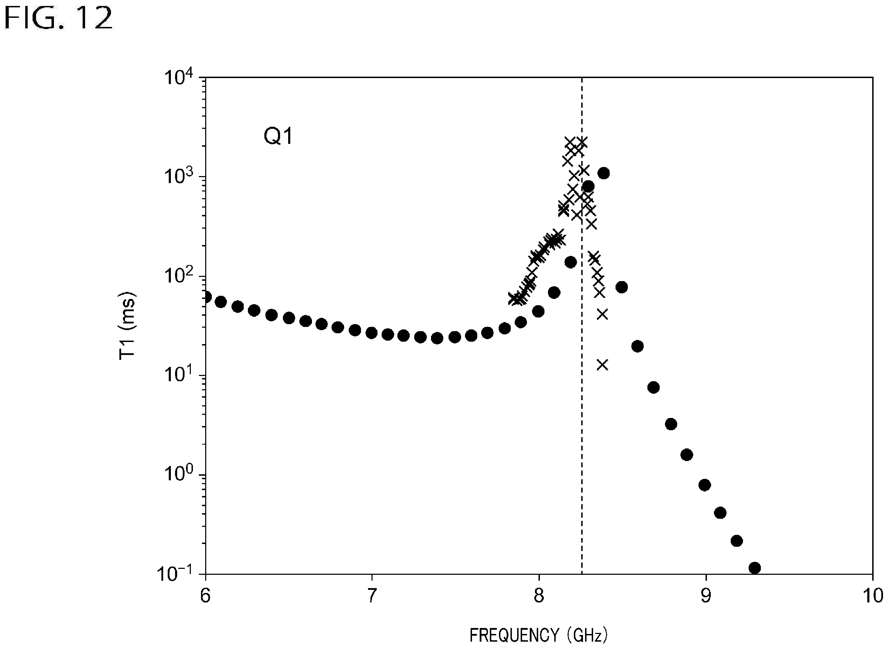

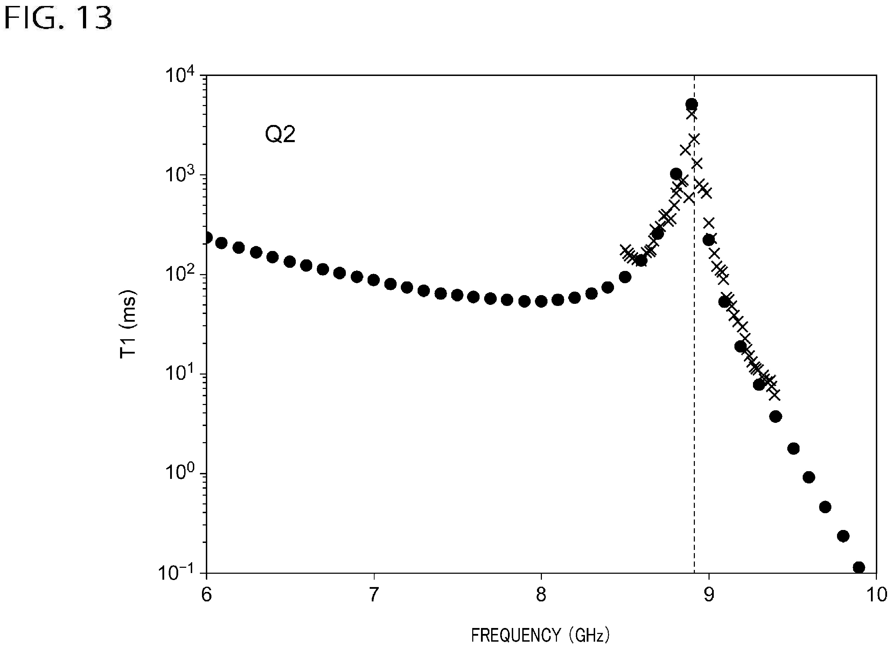

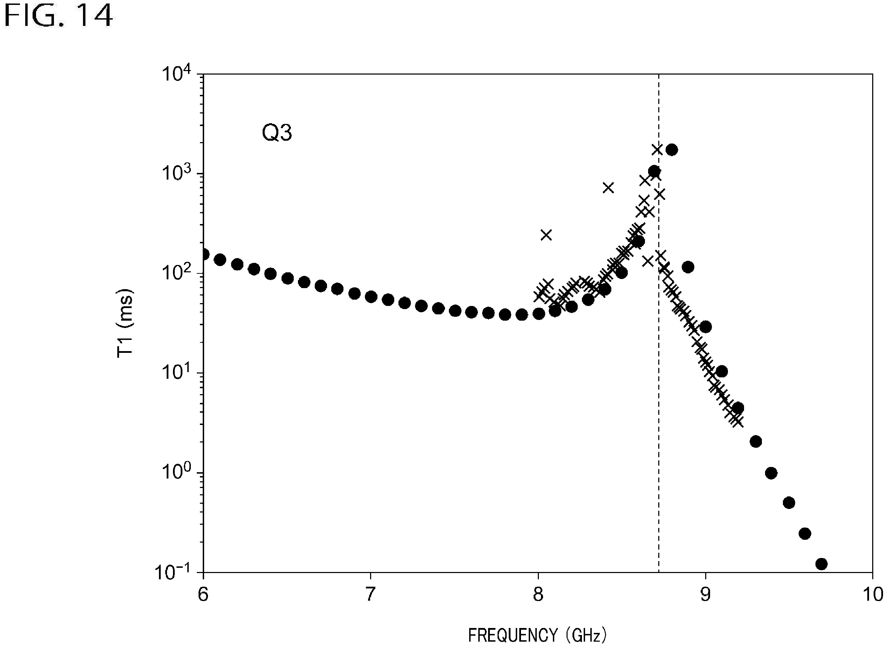

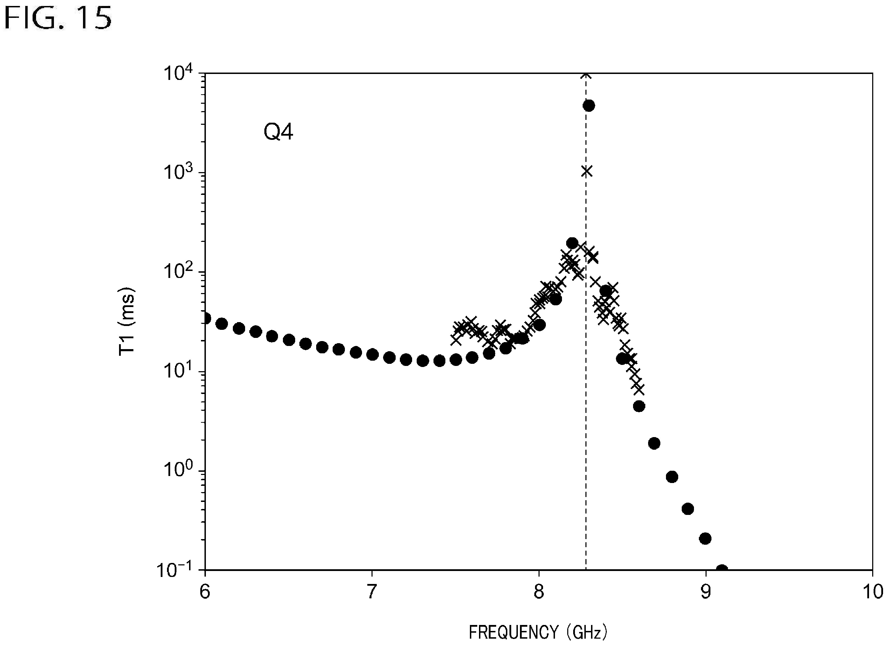

Figure 12 shows the frequency dependence of the radiation relaxation time T1 with respect to the first qubit 91. Figure 13 shows the frequency dependence of the radiation relaxation time T1 with respect to the second qubit 92. Figure 14 shows the frequency dependence of the radiation relaxation time T1 with respect to the third qubit 93. Figure 15 shows the frequency dependence of the radiation relaxation time T1 with respect to the fourth qubit 94. In both figures, crosses indicate experimental results and circles indicate simulation results. The experimental results are in good agreement with the simulations. As shown in Figures 12-15, it can be seen that for both qubits, there is a peak in the radiative relaxation time around the frequency of 8.2 GHz to 9 GHz. Thus, it was experimentally verified that the filter circuit 6 allows each individual parcel filter to also function as a notch filter and achieve the desired filter function.

In understanding the technical ideas abstracted from the embodiments and variations, the technical ideas should not be interpreted as limited to the contents of the embodiments and variations. The aforementioned embodiments and variations are merely concrete examples, and many design changes, such as modifications, additions, and deletions of components, are possible. In the embodiments, the contents where such design changes are possible are emphasized with the notation "embodiments". However, design changes are also permitted for contents without such notation.

Industrial applicability

The present disclosure is applicable to filter circuits, quantum devices and quantum computers.

REFERENCE SIGNS LIST

    1 filter circuit
    2 filter circuit
    3 filter circuit

4 filter circuit
5 filter circuit
6 filter circuit
11 readout-resonator
11a first readout-resonator section
11a1 first end
11a2 second end
11b second readout-resonator section
11b1 first end
11b2 second end
12 filter-resonator
12a first filter-resonator section
12a1 first end
12a2 second end
12b second filter-resonator section
12b1 first end
12b2 second end
13 coupler circuit
14 capacitor
15 inductor
20 multiconductor transmission line
21 first conductor
22 second conductor
30 capacitor
31 inductor
80 quantum device
81 data qubit
82 observation line
91 first qubit
92 second qubit
93 third qubit
94 fourth qubit
111 first readout-resonator
111a first readout-resonator section of first readout-resonator
111b second readout-resonator section of first readout-resonator
112 second readout-resonator
113 third readout-resonator
114 fourth readout-resonator
121 first filter-resonator
121a first filter-resonator section of first filter-resonator
131b second filter-resonator section of first filter-resonator
122 second filter-resonator
123 third filter-resonator
124 fourth filter-resonator
200 multiconductor transmission line
S1 step of forming readout-resonator
S2 step of forming filter-resonator
S3 step of coupling readout-resonator to data qubit
S4 step of coupling filter-resonator to observation line
S5 step of electromagnetically coupling readout-resonator to filter-resonator using capacitive coupling and inductive coupling in parallel
S11 step of providing readout-resonator component to be coupled to data qubit
S12 step of providing filter-resonator component to be coupled to observation line
S13 step of assembling readout-resonator component and filter-resonator component to be coupled to each other using capacitive coupling and inductive coupling in parallel
S21 step of performing bandpass filtering to transmit only around readout frequency of readout-resonator
S22 step of performing notch filtering to suppress energy relaxation of a qubit into observation line
S31 step of coupling electromagnetic field mode of qubit with electromagnetic field mode of readout-resonator

S32 step of coupling readout-resonator to observation line

**Claims**

1. A filter circuit comprising:

   a readout-resonator coupled to a data qubit; and
   a filter-resonator coupled to an observation line,
   wherein the readout-resonator and the filter-resonator are electromagnetically coupled to each other using capacitive coupling and inductive coupling in parallel.

2. The filter circuit according to claim 1,
   wherein the inductive coupling is realized by mutual inductance between the readout-resonator and the filter-resonator.

3. The filter circuit according to claim 1 comprising:

   a multiconductor transmission line situated in between the readout-resonator and the filter-resonator,
   wherein the capacitive coupling and the inductive coupling are realized by the multiconductor transmission line.

4. The filter circuit according to claim 3,

   wherein the readout-resonator comprises a first readout-resonator section with a first end connected to the data qubit and a second readout-resonator section with a first end grounded and
   wherein the multiconductor transmission line is situated in between the second end of the first readout-resonator section and the second end of the first filter-resonator section, and, the second end of the second readout-resonator section and the second end of the second filter-resonator section.

5. The filter circuit according to claim 4,

   wherein the notch frequency $\omega_f$ satisfies:
   [Equation 5]

$$\frac{1}{sinc(\omega_f \ell_c / v_c)} \left[ \frac{\cos(2\omega_f \tilde{\tau}_1) + \cos(2\omega_f \tilde{\tau}_2)}{1 + \cos(2\omega_f [\tilde{\tau}_1 + \tilde{\tau}_2])} \right] = \frac{Z_c^2 + Z_m^2}{Z_c^2 - Z_m^2} \qquad (4)$$

   , where the length of the multiconductor transmission line is $l_c$,
   where the propagation velocity of the wave propagating through the multiconductor transmission line is $v_c$,
   where the capacitance to ground per-unit-length of the first conductor and the second conductor of the multiconductor transmission line are $C_l$,
   where the inductance to ground per-unit-length of the first conductor and the second conductor of the multiconductor transmission line are $L_l$,
   where the capacitance per-unit-length between the first conductor and the second conductor of the multiconductor transmission line is $C_m$,
   where the inductance per-unit-length between the first conductor and the second conductor of the multiconductor transmission line is $L_m$,
   where the length of the second readout-resonator section of the readout-resonator is $l_{r1-G}$,
   where the length of the second filter-resonator section of the filter-resonator is $l_{r2-G}$ and
   where the variables of the distributed constant circuit are:
   [Equation 4]

$$\tilde{\tau}_1 = \frac{\ell_{r1-G}}{v} + \frac{\ell_c}{2v_c}, \quad \tilde{\tau}_2 = \frac{\ell_{r2-G}}{v} + \frac{\ell_c}{2v_c}, \quad v_c = \frac{1}{\sqrt{L_l(C_l + C_m)}}, \quad Z_c = \sqrt{\frac{L_l}{C_l + C_m}}, \quad Z_m = \sqrt{\frac{L_m}{C_m}} \qquad (3)$$

6. The filter circuit according to claim 5,

   wherein the notch frequency $\omega_f$ satisfies:
   [Equation 10]

$$\omega_f = \frac{\pi}{2(\tilde{\tau}_1 + \tilde{\tau}_2)} \qquad (9)$$

7. The filter circuit according to claim 6,
   wherein the coupling constant J between the readout-resonator and the filter-resonator is expressed by:
   [Equation 11]

$$J = \overline{\omega}_{rp} \frac{\pi^2}{32} \frac{\left(\dfrac{\overline{\omega}_{rp}}{\omega_f} - \dfrac{\omega_f}{\overline{\omega}_{rp}}\right)}{\cos\left(\dfrac{\pi \omega_f}{2\overline{\omega}_{rp}}\right)} \left(\frac{C_m}{C_c + C_m}\right) \sin\left(\frac{\omega_f \ell_c}{v_c}\right) \qquad (10)$$

8. The filter circuit according to claim 3, comprising:
   a capacitor for coupling in addition to the multiconductor transmission line.

9. The filter circuit according to claim 3, comprising:
   a capacitor and an inductor for coupling in addition to the multiconductor transmission line.

10. The filter circuit according to claim 9, comprising:

    a capacitor and an inductor situated in between the readout-resonator and the filter-resonator,
    wherein the capacitive coupling and the inductive coupling are realized by the capacitor and the inductor situated in between the readout-resonator and the filter-resonator, respectively.

11. A quantum device comprising:

    a data qubit;
    an observation line; and
    the filter circuit according to any of claims 1 to 10,
    wherein the filter circuit is situated in between the data qubit and the observation line.

12. A quantum computer comprising:
    the quantum device according to claim 11.

13. A filter circuit comprising:

    one or more data qubits;
    one or more readout-resonators corresponding to each of the data qubits;
    one or more filter-resonators each having a characteristic corresponding to the resonant frequency of the readout-resonators;
    a coupler circuit situated in between the readout-resonators and the filter-resonators to electrically and magnetically couple the readout-resonators and the filter-resonators; and
    a common observation line,
    wherein the filter circuit has both bandpass filter characteristics near the readout frequency using the resonance of the filter-resonator, and notch filter characteristics near the qubit frequency using interference in the electrical and magnetic coupler circuit.

14. A method of manufacturing a filter circuit comprising a readout-resonator and a filter-resonator, comprising:

forming a readout-resonator;
forming a filter-resonator;
coupling the readout-resonator to a data qubit;
coupling the filter-resonator to an observation line; and
electro-magnetically coupling the readout-resonator to the filter-resonator using capacitive coupling and inductive coupling in parallel.

15. A method of assembling a filter circuit comprising:

providing a readout-resonator component to be coupled with a data qubit;
providing a filter-resonator component to be coupled with an observation line; and
assembling the readout-resonator component and the filter-resonator component to be electromagnetically coupled to each other using capacitive coupling and inductive coupling in parallel.

16. A method of filtering the readout frequency in dispersive readout of a qubit to an observation line comprising:

using the filter circuit according to any of claims 1 to 7;
bandpass filtering to transmit only around the readout frequency of the readout-resonator; and
notch filtering to suppress energy relaxation of the qubit into the observation line.

17. A method of dispersive readout of a qubit to an observation line comprising:

using the filter circuit according to any of claims 1 to 7;
coupling the electromagnetic field mode of the qubit to the electromagnetic field mode of the readout-resonator; and
coupling the readout-resonator to the observation line.

# FIG. 1

TO OBSERVATION LINE

TO DATA QUBIT

FIG. 2

EP 4 769 241 A1

EP 4 769 241 A1

## FIG. 3

TO DATA QUBIT

TO OBSERVATION LINE

11a

11

11b

20

30

12a

12

12b

3

FIG. 4

# FIG. 5

GND PATTERN

11 31 12

TO DATA QUBIT

TO OBSERVATION LINE

30

4

EP 4 769 241 A1

FIG. 6

EP 4 769 241 A1

5

# FIG. 7

EP 4 769 241 A1

80

FIG. 8

FIG. 9

## FIG. 10

TO OBSERVATION LINE

6

1.2mm

# FIG. 11

91

111

111b

111a

121b

20

121a

121

TO OBSERVATION LINE

6

FIG. 12

FIG. 13

EP 4 769 241 A1

FIG. 14

FIG. 15

EP 4 769 241 A1

FIG. 16

## INTERNATIONAL SEARCH REPORT

| International application No. |
| --- |
| **PCT/JP2024/027820** |

| A. | CLASSIFICATION OF SUBJECT MATTER |
| --- | --- |

*G06N 10/40*(2022.01)i; *G06N 10/70*(2022.01)i; *H10N 60/00*(2023.01)i
FI:  G06N10/40; G06N10/70; H10N60/00 Z

According to International Patent Classification (IPC) or to both national classification and IPC

| B. | FIELDS SEARCHED |
| --- | --- |

Minimum documentation searched (classification system followed by classification symbols)

G06N10/00-10/70; H10N60/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2018-533253 A (NORTHROP GRUMMAN SYSTEMS CORPORATION) 08 November 2018 (2018-11-08)<br>entire text, all drawings | 1-17 |
| A | JP 2023-30019 A (NEC CORPORATION) 07 March 2023 (2023-03-07)<br>entire text, all drawings | 1-17 |
| A | US 11588472 B1 (GOOGLE LLC) 21 February 2023 (2023-02-21)<br>entire text, all drawings | 1-17 |
| A | US 2016/0112031 A1 (INTERNATIONAL BUSINESS MACHINES CORP.) 21 April 2016 (2016-04-21)<br>entire text, all drawings | 1-17 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **30 September 2024** | **08 October 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/027820**

| Patent document cited in search report | | | Publication date (day/month/year) | Patent family member(s) | | | Publication date (day/month/year) |
|---|---|---|---|---|---|---|---|
| JP | 2018-533253 | A | 08 November 2018 | US | 9438246 | B1 | |
| | | | | WO | 2017/082983 | A2 | |
| | | | | EP | 3344576 | B1 | |
| | | | | KR | 10-2018-0043802 | A | |
| JP | 2023-30019 | A | 07 March 2023 | US | 2022/0263467 | A1 | |
| | | | | entire text, all drawings | | | |
| | | | | WO | 2021/014887 | A1 | |
| US | 11588472 | B1 | 21 February 2023 | (Family: none) | | | |
| US | 2016/0112031 | A1 | 21 April 2016 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. D. REED et al.** Fast Reset and Suppressing Spontaneous Emission of a Superconducting Qubit. *Appl. Phys. Lett.*, 2010, vol. 96 (20), 203110
- **N. BRONN et al.** Broadband Filters for Abatement of Spontaneous Emission in Circuit Quantum Electrodynamics. *Applied Physics Letters*, 2015, vol. 107 (17), 172601
- **N. T. BRONN et al.** Reducing spontaneous emission in circuit quantum electrodynamics by a combined readout/filter technique. *IEEE Trans. Appl. Supercond.*, 2015, vol. 25 (5), 1-10
- **Y. SUNADA et al.** Fast Readout and Reset of a Superconducting Qubit Coupled to a Resonator with an Intrinsic Purcell Filter. *Phys Rev. Appl.*, 2022, vol. 17, 044016
- **J. HEINSOO et al.** Rapid high-fidelity multiplexed readout of superconducting qubits. *Phys. Rev. Appl.*, 2018, vol. 10 (3), 034040
- **J. F. MARQUES**. All-microwave leakage reduction units for quantum error correction with superconducting transmon qubits. *arXiv preprint arXiv:2302.09876*, 2023
- **C. R. PAUL**. *Analysis of multiconductor transmission lines*, 2007
- **C. R. PAUL**. Solution of the transmission-line equations under the weak-coupling assumption. *IEEE Trans. Elec. Comp.*, 2002, vol. 44 (3), 413-423